# EUROPEAN PATENT APPLICATION

(11) **EP 1 391 932 A1**
(43) Date of publication of application: **25.02.2004**
(21) Application number: 02255864.7
(22) Date of filing: 22.08.2002
(51) Int. Cl.: H01L 27/146, H04N 3/15

(54) **Solid state image sensor**

(71) Applicant: STMicroelectronics Limited, Marlow, Buckinghamshire SL7 1YL (GB)
(72) Inventor: Raynor, Jeff, Edinburgh EH12 5BD (GB)
(74) Representative: Jones, Keith William

(57) **Abstract**

An active pixel image sensor is formed on a P-epitaxial layer (10) on top of a P substrate (12). Each pixel consists of an N-well (14) acting as a collection node and a number of transistors. The pixel transistors comprise only NMOS transistors formed in P-wells 16. Circuits are described in which the in-pixel transistors cooperate with off-pixel PMOS transistors to form ADC circuits.

## Description

This invention relates to solid state image sensors with active pixels.

As is well known, in active pixel image sensors an area of the pixel acts as a photodiode, with photon-generated current being integrated on the self-capacitance of the photodiode. This charge is essentially an analog representation of light received at that pixel during the exposure period. Where a digital signal is desired, it is necessary to provide some means for A-D conversion.

Most active pixels in current use one or more A-D converters located off the image plane. This maximises the light-converting properties of the image plane, but at the expense of requiring a relatively complex switching or multiplexing arrangement to transfer pixel signals values to the A-D converter(s).

It has been proposed to use layouts in which each pixel has its own A-D converter; see for example US Patent 5,461,425 (Fowler et al), US Patent 5,801,657 (Fowler et al), US Patent 6,271,785 (Martin), and IEEE Journal Solid State Physics, December 2001, Vol 36, No 12, p2049 et seq (Kleinfelder et al).
However, such prior proposals have the disadvantage that the additional circuitry in each pixel severely reduces the ability of the pixel to collect photogenerated electrons, and thus severely reduces sensitivity.

The invention is defined in claim 1.

Preferred features and advantages of the present invention will be apparent from the other claims, and from the following description.

Embodiments of the invention will now be described, by way of example only, with reference to the drawings, in which:
Figure 1 illustrates a pixel in a prior art image sensor;
Figure 2 is a circuit diagram showing one method of use of the pixel of Figure 1;
Figure 3 illustrates a pixel in an image sensor according to one embodiment of the invention;
Figure 4 is a circuit using the pixel of Figure 3;
Figures 5 and 6 are timing diagrams illustrating the operation of the circuit of Figure 4;
Figure 7 is a timing diagram for a modified form of operation;
Figure 8 is a timing diagram showing a further modified mode of operation;
Figure 9 shows part of the circuit of Figure 4 in greater detail;
Figure 10 shows an alternative to Figure 9; and
Figures 11, 12 and 13 show modifications to the circuit of Figure 4.

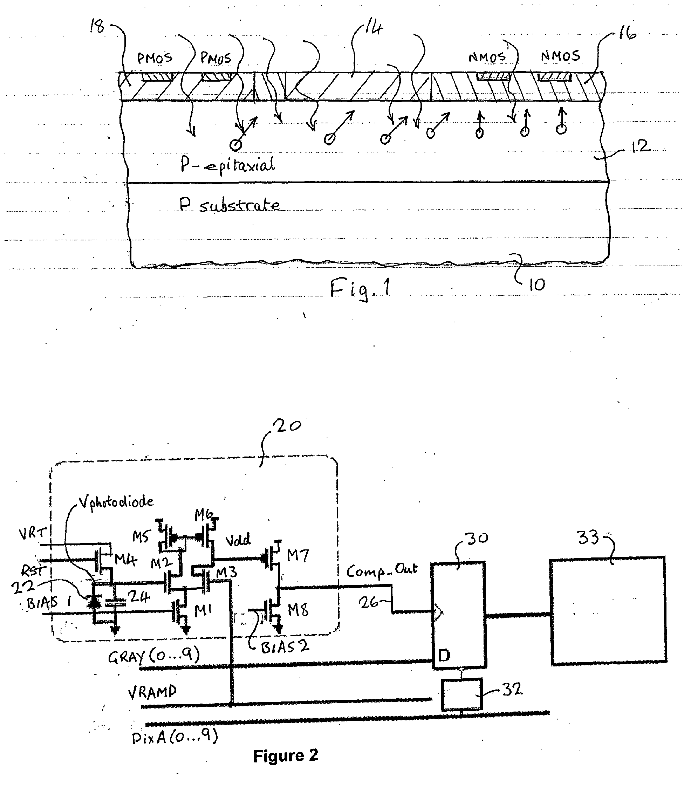

Figure 1 shows a prior art approach to an image sensor having in-pixel circuitry such as ADC. The sensor is formed on a P-epitaxial layer 12 overlying a P substrate 10. The top part of the P-epitaxial layer 12 is doped to provide the circuit components, namely an N-well 14 forming a collection node, NMOS transistors in a P-well 16, and PMOS transistors in an N-well 18.

For correct operation, the P-well 16 is biased to Vss (= ground/0V), and the N-well is biased to Vdd, typically 3.3V or 1.8V. The collection node 14 is biased to a voltage between Vss and Vdd.

Light is absorbed by the silicon at a depth which is wavelength dependent. Typically, visible light generates a substantial proportion of electrons at a depth which is greater than the wells 14,16,18. The collection node 14 as shown in Figure 1 will collect electrons that are generated directly beneath it. Those electrons which are generated close to the border of the collection node 14 and the P-well 16 are attracted to the positive potential of the collection node 14 and are collected. However, these electrons which are generated underneath or close to the N-well 18 are attracted to the positive bias of the N-well and are not collected. This corresponds to a loss of sensitivity of the pixel.

Figure 2 illustrates a circuit of the sensor of Figure 1. One pixel 20 is shown, which includes the collection node 14 shown as the equivalent diode 22 and capacitance 24. NMOS transistors M1-M4 control operation of the pixel, as will be described in more detail below. A comparator is formed by PMOS transistors M5-M7 and NMOS transistor M8, giving an output on line 26 when the sampled pixel voltage equals a ramp voltage Vramp on line 28.

A number of schemes are possible for using the change of state of the comparator. In the example shown, the line 26 sets an N-bit latch 30 according to a 10-bit gray scale. The latch 30 could be inside or outside the pixel. The latch 30 for a given pixel is enabled at the appropriate time by a decode circuit 32. The latch thus outputs a 10-bit representation of the pixel value, in this example to a frame store 33.

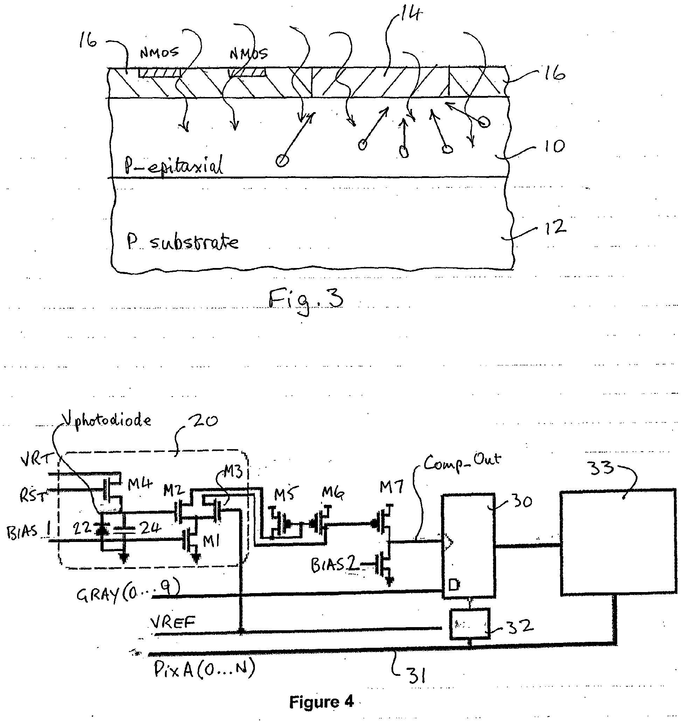

Turning to Figure 3, the invention in this embodiment once again has a P-epitaxial layer 10 over a P substrate 10. A collection node 14 is formed as an N-well. The surrounding surface is formed as a P-well 16 with amplification transistors provided by NMOS transistors only. The collection node 14 and P-well 16 may be contiguous, as shown, or may be separated by an insulation or isolation.

Thus, the sensor of Figure 3 contains no N-well other than the collection node 14. Electrons generated in the epitaxial layer 10 are attracted to the most positive point in the pixel, which is now the collection node 14, thus increasing the sensitivity.

Figure 4 shows one possible circuit making use of this. As discussed, the pixel 20 contains only NMOS transistors. Transistor M4 is used to reset the pixel voltage. Transistors M1-M3 form a long tail pair, with M1 forming a current source to M2 and M3. The long tail pair is connected to a current mirror formed by PMOS transistors M5 and M6 located off the pixel.

After reset, the voltage on the gate of M2 is higher than Vref (gate of M3). More current flows through M3 than M2 and hence more through M5 than M6. This keeps the gate of M7 high and the output "Comp_out" low.

After some time, dependent on the amount of light falling on the pixel, the voltage "Vphotodiode" will be lower than that on the gate of M3. When this happens, more current will flow through M3 than M2 and hence more through M6 than M5. This takes the gate of M7 low and the output Comp_out goes high.

The time that this transition takes place is stored using the N-bit latch 30 (in this example 10-bit). In the arrangement of Figure 4, there is an external current mirror and latch for each pixel. Typically, the outputs of the pixel latches are commoned onto a bus, and an address bus 31 and select circuit 32 are used to enable the bus output.

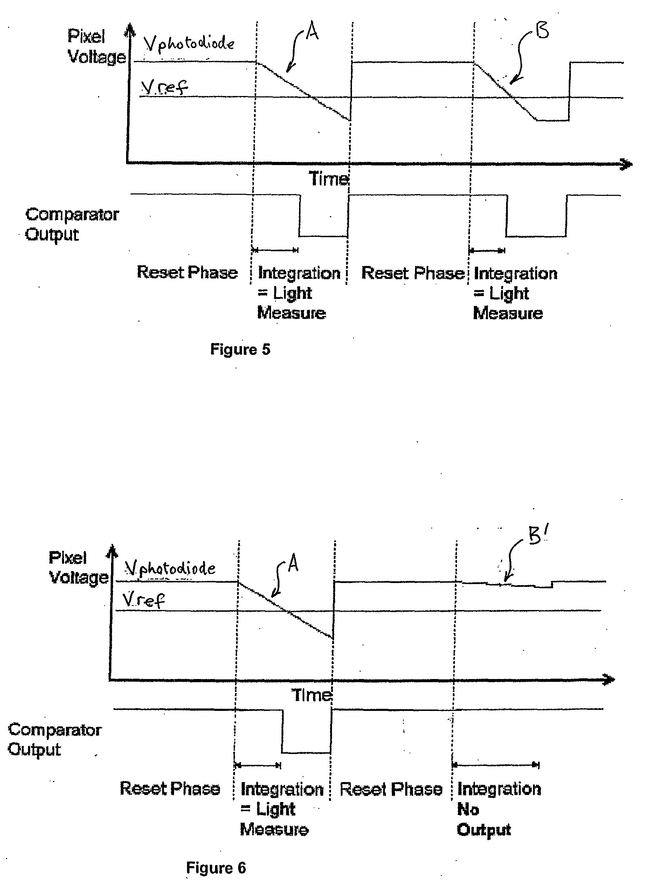

Figure 5 illustrates the timing for the circuit of Figure 4. As will be seen at A and B, the greater the amount of light falling on the pixel, the steeper is the slope of the integrating waveform and the earlier the comparator changes state.

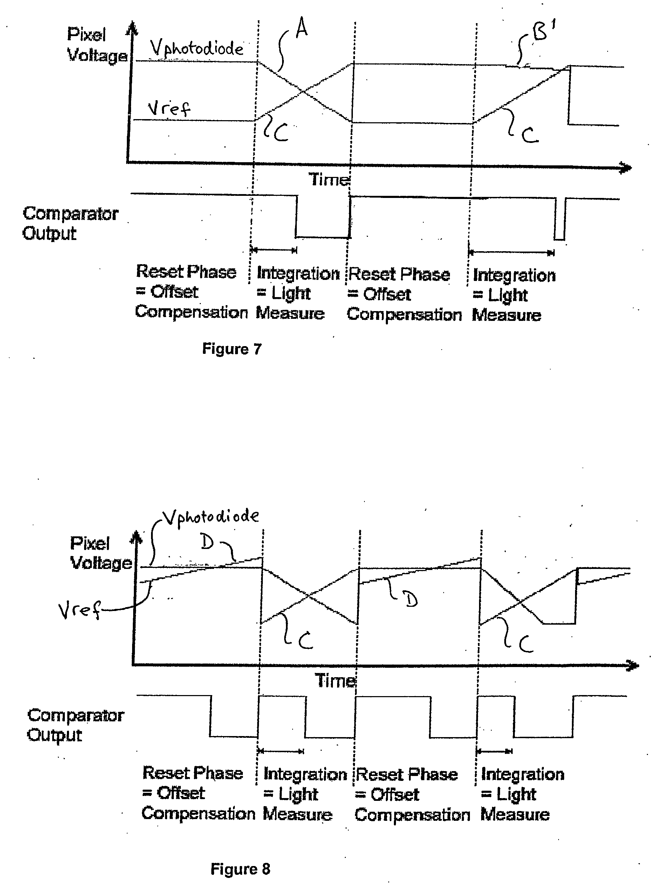

This arrangement has the disadvantage that, as shown at B' in Figure 6, low light levels produce a very shallow slope on Vphotodiode. This can be addressed either by lengthening the integration time, which reduces the speed of the whole system, or by setting Vref very close to the maximum of Vphotodiode, which makes the system very sensitive to noise. Figure 7 overcomes these limitations by providing Vref in the form of a piecewise linear ramp C during integration.

Figure 8 illustrates a further modification for use in mitigating fixed pattern noise. With careful layout, transistors M2 and M3 will match accurately.

However, there is likely to be an offset when the outputs from the long tail pair and the current mirror change states. Moreover, because of manufacturing tolerances this offset is likely to vary between pixels, causing fixed pattern noise.

Figure 8 shows an offset cancellation scheme. Reset transistor M4 is kept closed and the pixel is kept in reset. A ramp D is applied to Vref at the gate of M3. The system operates in a similar manner to the exposure of the pixels: when the comparator changes state the latch stores the count value on the "Gray(0...9)" bus and this count is stored in the frame store for subsequent subtraction from the output of the integration phase.

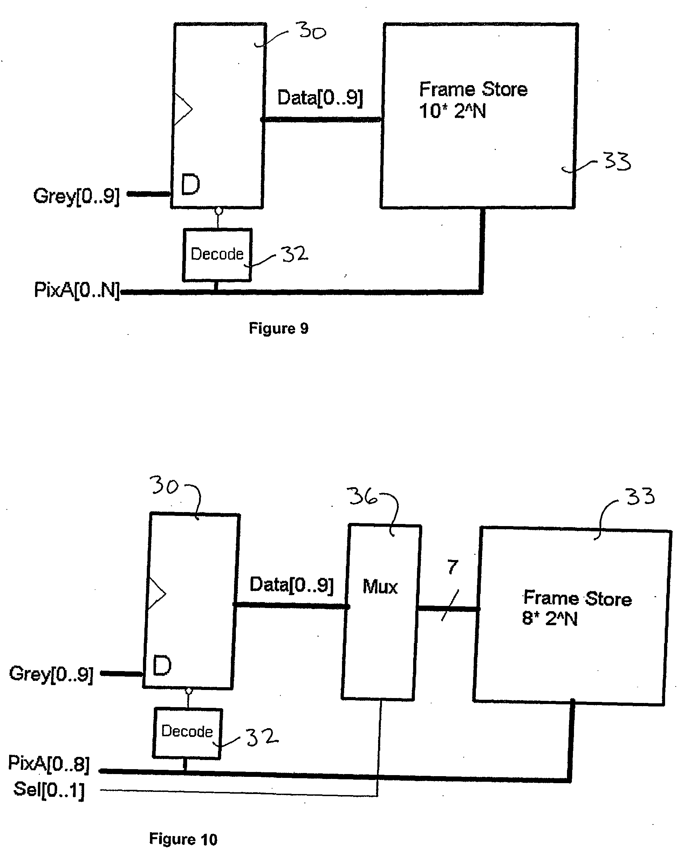

In the simplest implementation, the width of the frame store matches the width of the latches and the gray scale counter, i.e. 10 bits in the present example, as seen in Figure 9. However, to save space in the IC it is possible to use a narrower width of frame store and a selector circuit so that only the most relevant 8 bits, for example, are used. This is seen in Figure 10 where a multiplexer 36 is sued to select the 8 most significant bits if the signal is large, or the least significant 8 bits if the signal is small.

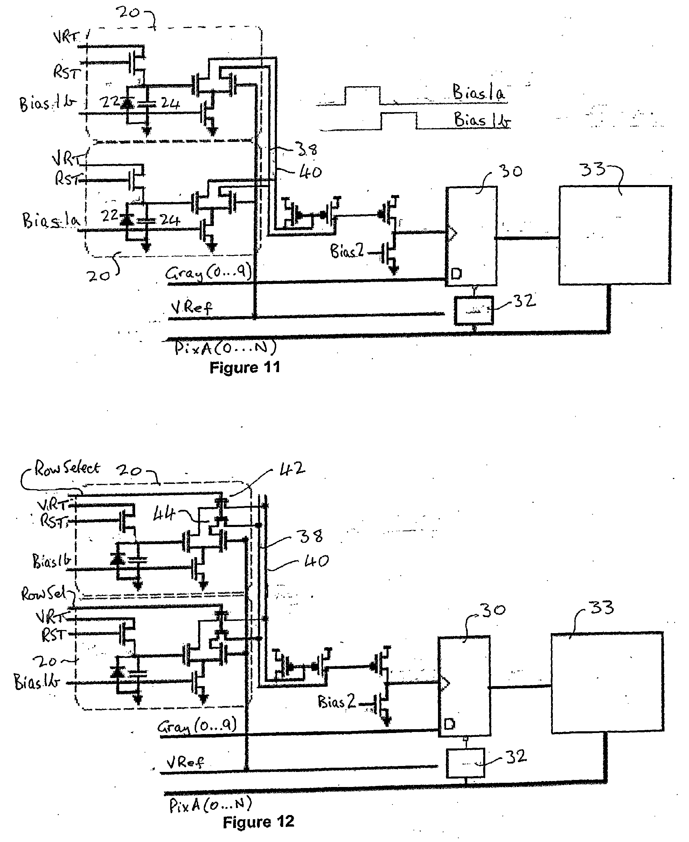

The foregoing description assumes that each pixel has its own current mirror and latch. This is feasible for small arrays, but for larger arrays it becomes necessary to share the current mirrors and latches between many pixels. In the system shown in Figure 11, the "Bias1" signal to the current load in the long tail pair is used to enable each of the rows in sequence. When Bias1 is low the pixel's readout is disabled, enabling the pixel to set to a suitable level. When Bias1 goes high the long tail pair is enabled and the difference between the photodiode voltage and Vref is output as a current difference on lines 38 and 40. The control signal for Bias1 is added to the address bus PixA(0...9) so that the output from the latch is written into the appropriate memory location.

For larger arrays, the parasitic effect of the drains from all the pixels in the column will slow access. To avoid this, as seen in Figure 12, NMOS FETs 42 and 44 are inserted at each pixel into both legs of the long tailed pair and are used to multiplex the output onto the lines 38 and 40.

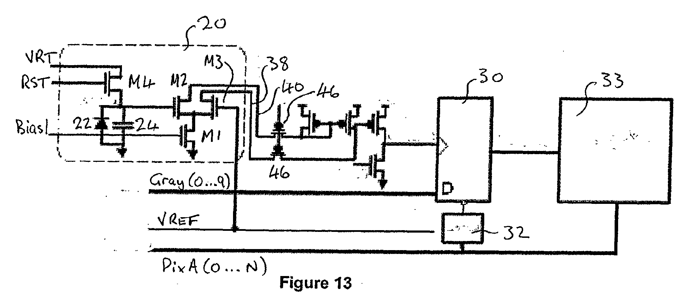

Alternatively or additionally, cascode transistors 46 can be used (as seen in Figure 13) to reduce the effects of stray capacitance on the lines 38 and 40 from the pixels.

The foregoing embodiments have been described in terms of a P-type substrate, with the collection node formed as an N-well and only NMOS transistors within the pixel. In principle, this could be inverted with the substrate N-type, the collection node a P-well and only PMOS transistors within the pixel.

The invention provides image sensors in which the pixels have greater sensitivity than in the prior art. Also, the pixels have a balanced readout which provides greater noise immunity than in the older analog readout mechanisms.

Greater sensitivity give a sensor which is able to operate at lower light levels: a significant requirement for cameras. systems which incorporate their own light source require less power to illuminate the pixel, leading to reduced power consumption.

## Claims

1. A solid state image sensor comprising a doped single crystal chip, one face of the chip forming an active pixel array; said face being formed on a P substrate by a P-epitaxial layer on which are formed pixels each comprising:
an N-well acting as a collection node,
one or more P-wells adjacent the N-well, and
in-pixel circuit elements comprising as active elements only NMOS transistors in at least one said P-well.

2. A solid state image sensor as defined in claim 1 but with N and P reversed.

3. An image sensor according to claim 1 or claim 2, in which said in-pixel circuit elements form part of an analog-to-digital converter which also comprises circuit elements external to the pixel.

4. An image sensor according to claim 3, in which said in-pixel circuit elements form an amplifier which is connected, directly or by switching, to a comparator external to the pixel and forming part of the analog to digital converter.

5. An image sensor according to claim 4, in which the in-pixel circuit elements form a long tail pair connected to receive the pixel photodiode voltage and a reference voltage, and providing a balanced output to an off-pixel current mirror which in turn is connected to said comparator.

6. An image sensor according to claim 5, including a counter in which a count is latched by a change of state of the comparator.

7. An image sensor according to claim 6, including a frame store, and in which the count latched in the counter is transferred to the frame store.

8. An image sensor according to claim 5, in which the reference voltage is ramped during the time when the photodiode is integrating photoinduced current.

9. An image sensor according to claim 5 or claim 8, in which the reference voltage is ramped during reset of the pixel to provide offset compensation.

10. An image sensor according to claim 6 or claim 7, in which each pixel is provided with a respective off-pixel comparator and counter.

11. An image sensor according to claim 6 or claim 7, in which a number of pixels in a given row or column share a single off-pixel comparator and counter, said pixels being enabled sequentially.

12. An image sensor according to claim 11, in which the outputs of the long tail pair in each pixel are multiplexed to a pair of output lines common to said number of pixels.

13. An image sensor according to claim 11 or claim 12, in which cascode transistors are provided in the outputs of each long tail pair.
